# EUROPEAN PATENT APPLICATION

(11) **EP 0 893 736 A1**
(43) Date of publication of application: **27.01.1999**
(21) Application number: 98901549.0
(22) Date of filing: 06.02.1998
(51) Int. Cl.: G03F 1/14, H01L 21/027

(54) **METHOD FOR STICKING A PELLICLE ON AN ARTICLE TO BE PROTECTED, PELLICLE-PROTECTED ARTICLES OBTAINED BY THE METHOD, PELLICLE FOR ULTRAVIOLET RAYS, AND CASE FOR PELLICLES**

(30) Priority: 10.02.1997 JP 26225/97; 13.02.1997 JP 29073/97
(71) Applicant: Mitsui Chemicals, Inc., Tokyo 100-6070 (JP)
(72) Inventor: TSUMOTO, Takamasa, Mitsui Chemicals, Inc., Kuga-gun, Yamaguchi 740-0061 (JP); SHIGEMATSU, Shigeto, Mitsui Chemicals, Inc., Kuga-gun, Yamaguchi 740-0061 (JP); NAKAGAWA, Hiroaki, Mitsui Chemicals, Inc., Kuga-gun, Yamaguchi 740-0061 (JP); KONDO, Masahiro, Mitsui Chemicals, Inc., Kuga-gun, Yamaguchi 740-0061 (JP)
(74) Representative: HOFFMANN - EITLE
(86) International application number: JP9800514
(87) International publication number: WO9835270

(57) **Abstract**

A method of sticking a pellicle to an item to be protected, comprising pressing the pellicle to the item to be protected, in the state of an adhesive with a hardness of up to 200 gf interposed between one end face of a pellicle frame and the item to be protected, at a sticking pressure not lower than an adhesion pressure intrinsic to the adhesive, so that the pellicle adheres to the item to be protected. A thus obtained item protected with a pellicle stuck thereto.

An adhesive furnished pellicle for ultraviolet with a wavelength of 140 to 200 nm, comprising a pellicle film, a pellicle frame adapted to hold the pellicle film in extended form through an adhesive (a) layer and an adhesive (b) layer capable of securing the pellicle frame to an item to be protected, wherein the amount of generated compound does not exceed 200 ppm, said compound being one which is generated from the adhesive (a) layer and the adhesive (b) layer and can be adsorbed on or absorbed by the pellicle film and which, when irradiated with ultraviolet with a wavelength of 140 to 200 nm, generates radicals, and a case for this pellicle.

A process for producing an item protected with a pellicle stuck thereto, which enables preventing the adhesion of dust to an item such as a mask or a reticle; an adhesive furnished pellicle for ultraviolet with a wavelength of up to 200 nm, which is excellent in light resistance (durability); and a pellicle case are provided.

## Description

### TECHNICAL FIELD

The present invention relates to a method of sticking a pellicle to a substrate such as a mask or a reticle (hereinafter may be simply referred to as "a mask") and a substrate with a pellicle stuck thereto produced by the above method. More particularly, the present invention relates to a method of sticking with the use of a specified adhesive a pellicle (protector for a mask or the like), which is employed to prevent dust from adhering to the mask or the like used in the photolithography of the process for manufacturing integrated circuits, liquid crystal displays, etc., to a substrate (hereinafter may be referred to as "mask substrate") of such as a mask or a reticle and relates to a mask substrate with a pellicle stuck thereto produced by the above method.

Furthermore, the present invention relates to an adhesive furnished pellicle which is suitably employed especially when use is made of an exposure light source of ultraviolet with a wavelength as small as 140 to 200 nm, and relates to a pellicle case.

### BACKGROUND ART

It is common practice to employ a substrate such as a mask or a reticle, for example, when highly integrated circuits (LSI) are manufactured according to photolithography in the semiconductor manufacturing process. If foreign matter such as dust adheres onto the mask, the foreign matter is projected and transferred onto a semiconductor wafer, thereby increasing the occurrence of defective products.

For avoiding the adhesion of foreign matter such as dust onto the mask, the mask substrate commonly has its one side or both sides fitted with a pellicle capable of functioning as a light transmissive dust protector.

This pellicle comprises a pellicle frame (holding frame) composed of, for example, aluminum and having a size sufficient to enclose a mask pattern and a transparent thin film (pellicle film) attached to one end face of the pellicle frame with a given spacing from the surface of the mask. This pellicle is stuck to the mask by applying an adhesive to the other end face of the pellicle frame or by the use of an adhesive tape at the other end face.

In the sticking of the pellicle, i.e., protector for the mask to the mask with the use of, for example, an adhesive, it is required that no gap be made between the mask or the like and the protector therefor. Thus, it is required to bond the entire circumference and entire bottom face of the pellicle frame to the mask substrate in close contact relationship without any gap therebetween so that sealing (tight shut) is effected to thereby avoid the formation of gap permitting the passage of dust or the like.

However, the mask is likely to have a strain during the press sticking of the protector for the mask to the mask. When there is even a slight strain, the problem is encountered such that, in the transfer of the mask pattern onto a semiconductor wafer through the mask by exposure, double photographing of the pattern or partial enlargement is likely to occur to thereby result in defective products.

Further, there is the problem such that, the larger the protector for the mask, the greater the sticking force required to stick the protector for the mask to the mask, thereby increasing the danger of producing defective products.

The inventors have conducted extensive and intensive investigations with a view toward solving the above problems. As a result, it has been found that the use of a specified adhesive at the time of sticking the pellicle to an item to be protected, for example, a mask substrate and the pressing of the pellicle to the substrate at a specified press force (sticking pressure) so that the pellicle and the substrate can adhere to each other within a short period of time in the state that the interior of the pellicle is completely sealed from outside, ready detachment of the pellicle from the mask substrate can be prevented and strain of the substrate can be avoided.

As mentioned above, the pellicle comprises a pellicle frame (holding frame) of, for example, aluminum and, attached onto one end face thereof, a transparent pellicle film (light transmissive dust protecting film). The pellicle is so constructed that the pellicle film is held with an appropriate spacing from the surface of the mask substrate by means of the pellicle frame.

Thus, in the transfer of the wiring pattern on mask substrate surface onto the wafer, the surface of the mask substrate and the surface of the pellicle film are different from each other in image forming distance, so that, even if foreign matter is adhering to the pellicle surface, the foreign matter is not transferred onto the wafer.

Therefore, covering the mask with the pellicle enables preventing the contamination of foreign matter from outside with the result that not only the production efficiency of photolithography but also the yield of the production of semiconductor elements can be enhanced.

The above pellicle film is required to have satisfactory film strength, durability and light transmittance, especially, light transmittance at exposure wavelength. Cellulose materials such as nitrocellulose and cellulose propionate are commonly employed as the material of pellicle film for light such as g-rays (436 nm) and i-rays (365 nm).

In recent years, in the semiconductor process, there is a tendency to reduce the wavelength of exposure light source so that the degree of integration is increased in accordance with the pattern fining. For example, the writing with the use of KrF excimer laser (λ = 248 nm) as exposure light source is now being realized. Moreover, the application of ultraviolet having a wavelength as small as up to 200 nm is being studied, and, especially, the employment of ArF excimer laser (λ = 193 nm) is most likely.

The smaller the wavelength of laser radiation, the greater the photon energy thereof. For example, the energy of ArF excimer laser is 6.4 eV (147 kcal/mol), which is greater than the dissociation energy of C-C bond (83.6 kcal/mol) and dissociation energy of C-H bond (98.8 kcal/mol) of organic polymer.

However, the transmittance of cellulose materials as conventional pellicle constituting materials is not satisfactory for light of a short wave range of up to 300 nm. Further, the cellulose materials readily suffer from photodecomposition (photodegradation) upon being irradiated with the ultraviolet wave range radiation, especially, ArF excimer laser with the result that the pellicle cannot stand practical use.

Therefore, there is a demand for a pellicle which scarcely absorbs ultraviolet with a wavelength of, especially, up to 200 nm and which is not decomposed by light absorption. For example, it has been proposed to use as a pellicle film material a fluororesin which is excellent in the short wave ultraviolet range light transmittance.

However, the inventors' studies of pellicles having excellent light resistance have revealed that, even when a pellicle film is composed of a material having excellent light transmittance, such as a fluororesin, the pellicle occasionally exhibits satisfactory light resistance (durability).

Further studies have been conducted. As a result, it has been found that the above lowering of the light resistance of the pellicle film is caused by the attachment onto the pellicle film of a compound which generates radicals upon being irradiated with ultraviolet with a wavelength of 140 to 200 nm, which attachment occurs upon the contact of the pellicle film with another member at the time of manufacturing of the pellicle or at the time of use of the pellicle. Furthermore, it has been found that the light resistance of the pellicle can be maintained by making the pellicle from members which do not contain such a compound. The present invention has been completed on the basis of these findings.

### OBJECT OF THE INVENTION

The present invention has been made with a view toward solving the above problems of the prior art. It is an object of the present invention to provide a method of sticking a pellicle to an item to be protected, in which, with the use of a specified adhesive, a pellicle, i.e., a protector for a mask can be brought into close contact with an item to be protected, for example, a substrate such as a mask at a slight press force (also referred to as "sticking pressure" in the present invention) and stuck in the state that the interior of the protector for the mask is sealed from outside and in which, upon the sticking, the pellicle is not readily peeled from the mask substrate. It is another object of the present invention to provide an item protected with a pellicle stuck thereto, especially, a mask substrate with a pellicle stuck thereto which is obtained by the above method.

It is a further object of the present invention to provide an adhesive furnished pellicle for up to 200 nm ultraviolet which is excellent in light resistance (durability) and relates to provide a pellicle case.

### SUMMARY OF THE INVENTION

The method of sticking a pellicle to a substrate such as a mask according to the present invention comprises sticking a pellicle, said pellicle comprising a pellicle frame with a size sufficient to enclose a mask pattern and a transparent thin film attached to one end face of the pellicle frame, to a substrate of such as a mask or a reticle as an item to be protected, wherein the pellicle or the pellicle frame is pressed to the item to be protected in the state that an adhesive with a hardness of up to 200 gf is interposed between the other end face of the pellicle frame and the item to be protected, at a sticking pressure not lower than an adhesion pressure intrinsic to the adhesive, so that the pellicle adheres to the item to be protected.

In the present invention, it is preferred that the hardness of the adhesive be in the range of from 60 to 200 gf.

In the present invention, the adhesive preferably has a 180-degree peeling bond strength of at least 0.6 kg/25 mm width. Further, it is preferred that the hardness of the adhesive be in the range of from 60 to 150 gf and that the adhesive has a 180-degree peeling bond strength of from 0.8 to 3 kg/25 mm width.

Moreover, in the present invention, it is preferred that the sticking pressure be not lower than the adhesion pressure intrinsic to the adhesive but do not exceed 20 kgf, and it is especially preferred that the sticking pressure be not lower than the adhesion pressure intrinsic to the adhesive but do not exceed 10 kgf.

In the present invention, the sticking pressure is preferably maintained for a period of from 10 to 30 sec.

The item protected with a pellicle stuck thereto according to the present invention is obtained by any of the above methods.

The adhesive furnished pellicle of the present invention is one for ultraviolet with a wavelength of 140 to 200 nm, and
comprises a pellicle film, a pellicle frame (holding frame) adapted to hold the pellicle film in extended form through an adhesive (a) layer and an adhesive (b) layer capable of securing the pellicle frame to an item to be protected, i.e., a substrate of such as a mask or a reticle,
wherein the amount of generated compound does not exceed 200 ppm, said compound being one which is generated from the adhesive (a) layer and the adhesive (b) layer and can be adsorbed on or absorbed by the pellicle film and which, when irradiated with ultraviolet with a wavelength of 140 to 200 nm, generates radicals.

The above compound which, when irradiated with ultraviolet with a wavelength of 140 to 200 nm, produces radicals is, for example, an aromatic compound, a ketone or a nitrogenous compound.

The pellicle case of the present invention is a case adapted to contain the above pellicle, wherein the amount of generated compound does not exceed 200 ppm, said compound being one which is generated from the case and can be adsorbed on or absorbed by the pellicle film and which, when irradiated with ultraviolet with a wavelength of 140 to 200 nm, generates radicals.

The present invention provides a method of sticking a pellicle to an item to be protected such as a mask, in which a pellicle, i.e., a protector for a mask can be brought into close contact with an item to be protected such as a mask at a slight press force (sticking pressure) and stuck in the state that the interior of the protector for the mask is sealed from outside and in which, upon the sticking, the pellicle is not readily peeled from the protected item such as the mask substrate. Further, the present invention provides an item protected with a pellicle stuck thereto wherein the mask is free from strain and which is obtained by the above method.

The above pellicle for ultraviolet of the present invention exhibits excellent light resistance when use is made of an exposure light source of 140 to 200 nm ultraviolet.

### BRIEF DESCRIPTION OF THE DRAWING

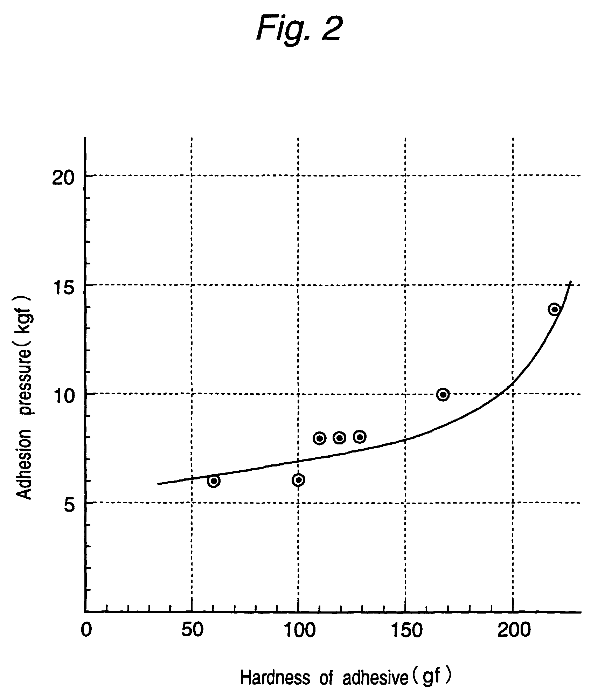

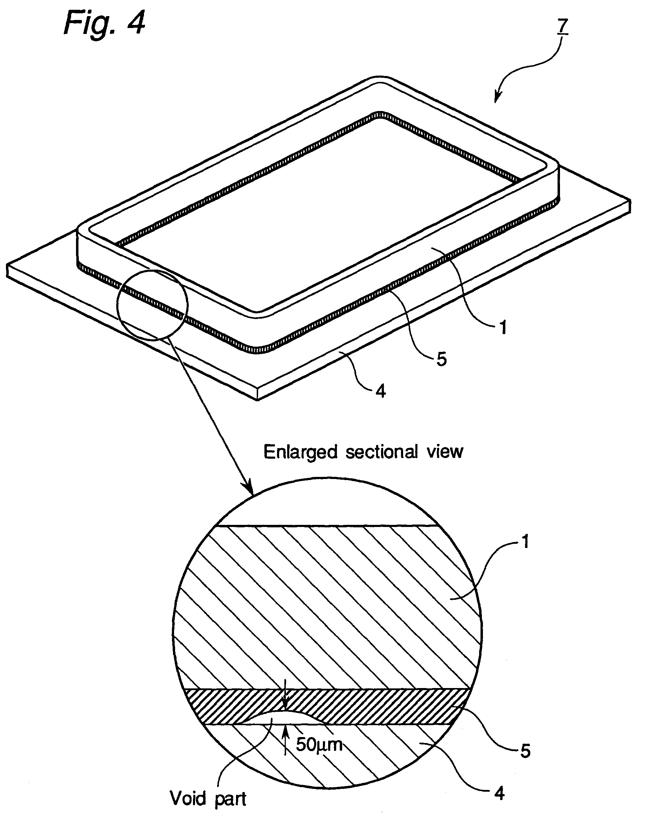

Fig. 1 is a sectional view of a substrate with a pellicle stuck thereto, specifically, a sectional view of the case that a pellicle (protector for the mask) is stuck on a mask.
Fig. 2 shows the relationship between the hardness of adhesive and the adhesion pressure, exhibited at a sticking time of 30 sec.
   Illustratively, this Fig. 2 plots the sticking pressure (referred to as "adhesion pressure intrinsic to the adhesive") at which the adhesion is effected without any voids in the adhesive layer as found when the bonding surface of the adhesive layer making the pellicle frame adhered to the substrate in the substrate with the pellicle stuck thereto is observed. The upward curve of Fig. 2 shows the relationship between the minimum sticking pressure required for completely sealing the bonding surface, namely, the adhesion pressure and the hardness of the adhesive.
   In Fig. 2, the axis of abscissas indicates the hardness of adhesive (unit: gf) while the axis of ordinates indicates the adhesion pressure (unit: kgf).

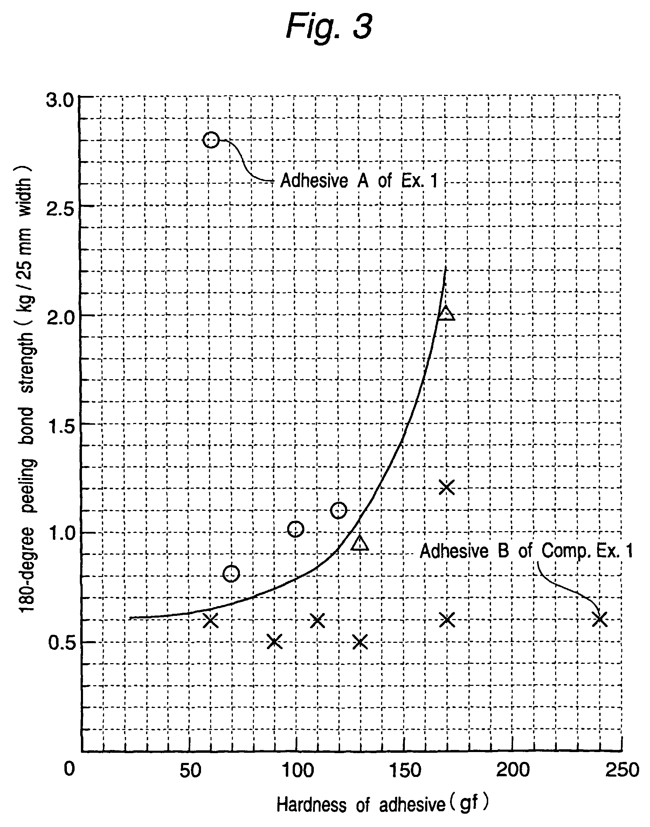

Fig. 3 shows the relationship between hardness and 180-degree peeling bond strength with respect to various adhesives.
   This Fig. 3 will be described below.
   The performance of adhesive (adhesive) was evaluated by bonding a pellicle frame to a substrate with the use of each of various adhesives having various hardnesses and 180-degree peeling bond strengths as indicated in Fig. 3 under the following conditions.
   Specifically, an adhesive coated pellicle frame was prepared by coating its bottom face with an adhesive so that an adhesive layer having a width of 1.5 mm and a thickness of 0.5 mm was formed. This adhesive coated pellicle frame was pressed to a mask substrate at a sticking pressure of 17 kgf for 30 sec to thereby effect sticking of the pellicle frame to the mask substrate. After the passage of 1 hr, the state of bonding surface was observed and the bonding characteristics of the adhesive were evaluated.
   For assessing the influence on bonding characteristics of any nonuniformity in the thickness of the adhesive layer provided by coating in the evaluation of the bonding characteristics of the adhesive, the bonding was effected in the state that a minute void part was formed between the substrate and the adhesive layer by inserting a 50 µm thick gauge covered with a PET film in a partial area of contact surfaces of the substrate and the adhesive layer. Thus, a local stress (force to separate by the resiliency due to the rubber elasticity of the adhesive) was compulsorily applied to the adhesive layer, thereby effecting the bonding (see Fig. 4).
   In Fig. 3, the axis of abscissas indicates the hardness of adhesive (gf) while the axis of ordinates indicates the 180-degree peeling bond strength (kg/25 mm width).
   In Fig. 3, the meanings of marks o, △, and x are as follows:
   mark o: the bonding surface is completely sealed, and desirable bonding condition free from voids and peeling is realized;
   mark △: although sealing is satisfactory, the bonding surface is separated upon application of external force probably because of the poor bond strength attributed to the presence of minute voids in the bonding surface constituting adhesive layer; and
   mark x: although separation does not occur, sealing is unsatisfactory and there are minute voids at the bonding surface.

   Fig. 3 shows adhesives which have the same hardness but have different 180-degree peeling bond strengths(see, e.g., hardness of 130 gf or 170 gf). This is because of testing of different varieties of adhesives whose resin and other component compositions are different from each other.
   It is apparent from Fig. 3 that the adhesives within the left upper zone of the curve of Fig. 3 are preferred for use in the present invention.
Fig. 4 shows how, for assessing the influence on bonding characteristics of any nonuniformity in the thickness of the adhesive layer provided by coating in the evaluation of the bonding characteristics of the adhesive as shown in Fig. 3, the bonding was effected in the state that a minute void part was formed between the substrate and the adhesive layer by inserting a 50 µm thick gauge covered with a PET film in a partial area of contact surfaces of the substrate and the adhesive layer.

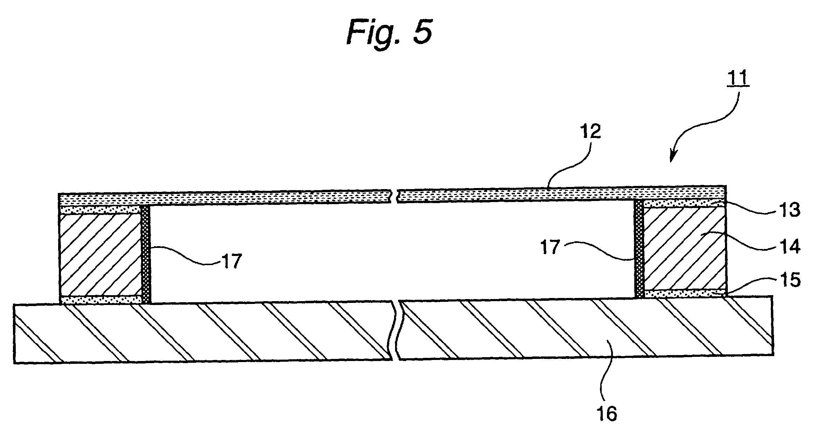

Fig. 5 shows one embodiment of the adhesive furnished pellicle of the present invention.

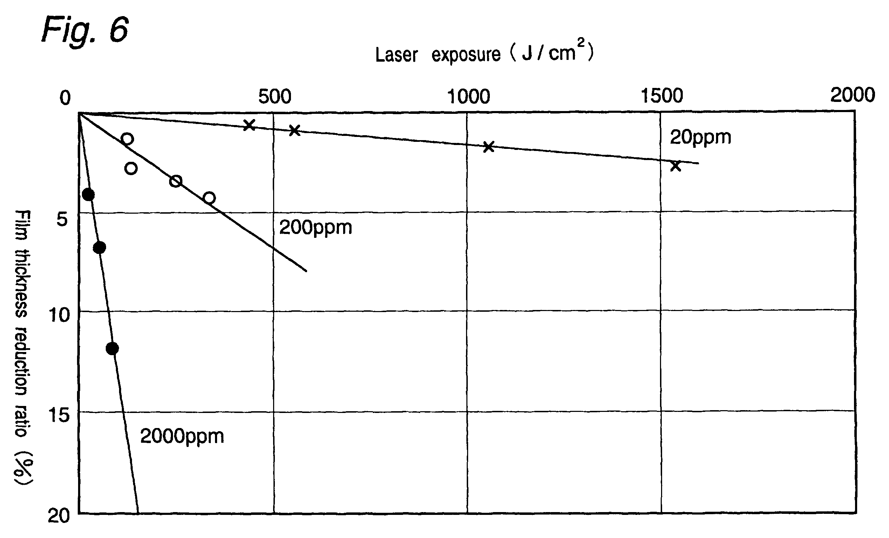

Fig. 6 shows the results of the light resistance test of Example 4.

### Description of Mark

1: pellicle frame,
1a: one end face (upper end face) of pellicle frame,
1b: other end face (lower end face) of pellicle frame,
2: thin film (pellicle film),
3: protector for a mask (pellicle),
4: mask (mask substrate), protected item,
4a: upper surface of mask substrate,
4c: surface of mask substrate brought into contact with other end face of pellicle frame,
5: adhesive, adhesive layer,
6: mask pattern,
7: substrate with pellicle stuck thereto,
11: adhesive furnished pellicle,
12: pellicle film,
13: adhesive (a) layer,
14: pellicle frame (holding frame),
15: adhesive (b) layer,
16: protected item (substrate) such as photomask or reticle, and
17: adhesive (c) layer.

### DETAILED DESCRIPTION OF THE INVENTION

With respect to the method of sticking a pellicle to an item to be protected, item protected with a pellicle stuck thereto which is obtained by the method, adhesive furnished pellicle for ultraviolet and pellicle case according to the present invention, preferred embodiments of the present invention will be described in detail below with reference to the appended drawings.

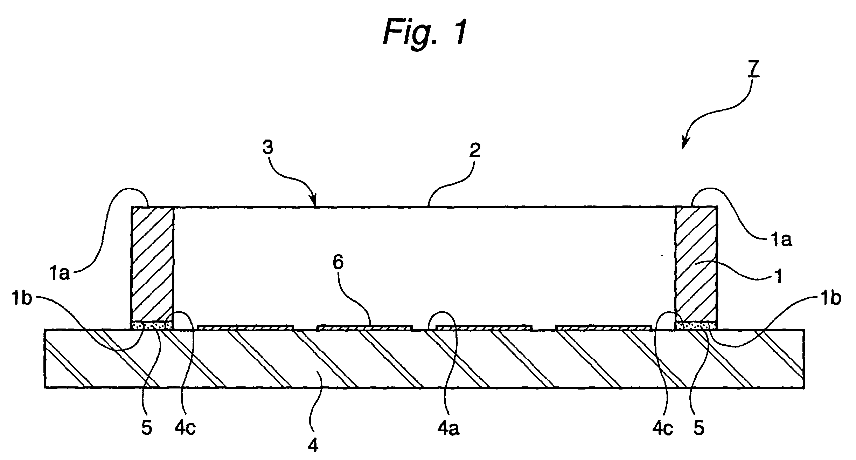

Fig. 1 is a sectional view of an item protected with a pellicle stuck thereto according to the present invention, specifically, a sectional view of a mask substrate with a pellicle stuck thereto (substrate with a pellicle stuck thereto) as a preferred embodiment of the invention.

### Substrate with a pellicle stuck thereto

The substrate with a pellicle stuck thereto 7 shown in Fig. 1 is so constructed that pellicle 3, namely, protector for a mask 3 is attached through adhesive 5 to one surface 4a of substrate 4 such as a mask or a reticle as an item to be protected. This pellicle 3 comprises pellicle frame 1 with a size sufficient to enclose mask pattern 6 and transparent thin film 2 attached to one end face 1a of the pellicle frame 1 with a given spacing from the surface of mask (mask substrate) 4, mask pattern 6, etc.

In the above substrate with a pellicle stuck thereto 7, the other side end face of the pellicle frame 1 is stuck in close contact relationship to the mask substrate 4 as an item to be protected through the adhesive 5, so that the interior of the pellicle 1 including the mask substrate 4 is completely sealed from outside.

### Production of substrate with pellicle stuck thereto

The above substrate with a pellicle stuck thereto 7 as shown in Fig. 1 is obtained by pressing the pellicle frame 1 or pellicle 3 to the substrate 4, in the state that the adhesive 5 with a hardness of up to 200 gf is interposed between the other end face 1b of the pellicle frame 1 constructing the pellicle 3 and the substrate 4, at a sticking pressure not lower than or higher than an adhesion pressure intrinsic to the adhesive 5, so that the pellicle 3 adheres to the substrate 4.

The adhesive and sticking pressure suitably employed in the present invention will be sequentially described below.

### 〈Pressure sensitive adhesive〉

In the present invention, adhesives prepared by loading a base polymer with various components such as a resin other than the base polymer, a tackifier, a thickener and a stabilizer can be used for sticking the pellicle frame 1 to the substrate 4. Examples of suitable base polymers include:
hot melt resins such as SEBS, ethylene vinyl acetate resin, butyl methacrylic resin, polystyrene, polyisobutylene and copolymers thereof; and
resins other than hot melt resins, such as silicone, urethane and acrylic adhesive resins. These adhesives can be used either individually or in combination.

More specifically, an example of the adhesives for use in the present invention comprises a base polymer of, for example, a styrene/conjugated diene block copolymer such as SEBS (styrene-(ethylene/butylene)-styrene block copolymer) and, blended therewith, a tackifier, a thickener and a stabilizer.

Among the above adhesives, those having a hardness of up to 200 gf, especially, 60 to 200 gf and, still especially, 60 to 150 gf are preferred in the present invention. The hardness of the adhesives can be measured with the use of, for example, rubber hardness meter GS-706 (JIS A type) manufactured by Teclock Corporation in accordance with Japanese Industrial Standard K 6301 (corresponding to ASTM D 2240).

In the present invention, the adhesive 5 with the above hardness is interposed between the other end face 1b of the pellicle frame 1 and the substrate 4. The interposition of the adhesive between the pellicle frame and the substrate may be effected by, for example, applying the adhesive 5 to the other end face 1b of the pellicle frame 1, or applying the adhesive 5 to both the other end face 1b and the surface 4c of the substrate 4 brought into contact with the other end face 1b, or applying the adhesive 5 to only the surface 4c of the substrate 4. However, from the viewpoint of operation efficiency, it is preferred to apply the adhesive 5 to the other end face 1b of the pellicle frame 1.

In the state that the adhesive 5 is interposed, the pellicle 3 or the pellicle frame 1 is pressed to and closely contacted with the substrate 4 and the pellicle 3 or the pellicle frame 1 is stuck to the substrate 4.

It is requisite that the pressure at which the sticking is performed be as large as at least the adhesion pressure intrinsic to the adhesive 5, as mentioned above.

### 〈Adhesion pressure and sticking pressure〉

In the present invention, the adhesion pressure is defined as follows.

Referring to Fig. 1, the terminology "adhesion pressure" used in the present invention means the sticking pressure at which, in the sticking, to the mask substrate 4, of the pellicle frame 1 having an adhesive layer 5 of 1.5 mm width and 0.5 mm thickness formed by applying the adhesive 5 to the other end face 1b of the pellicle frame 1, the substrate 4 and the adhesive layer 5 applied to the other end face 1b of the pellicle frame 1 completely adhere to each other without any separated portion, that is, no void part (separated part) is present between the adhesive layer 5 and the substrate 4.

The adhesion pressure will further be described in greater detail. For example, the surface of the adhesive layer formed by coating on a flat film or flat other end face 1b of the pellicle frame 1 is nearly flat but not completely flat and generally has minute irregularities. Therefore, for bonding in completely sealed condition such that there is no void part between the surface of the adhesive layer and the opposite member, for example, the bonding surface 4c of the substrate 4, the bonding must be performed by pressing so that protrudent regions, not shown, of the surface of the adhesive layer 5 are depressed to at least the level of recessed regions, that is, the surface of the adhesive layer becomes completely flat to thereby attain complete adherence to the flat surface of the opposite member.

In the pressing of the pellicle frame to the substrate, the resiliencies, at bonding, to the opposite member are different between minute recessed part and protrudent part present on the surface of the adhesive layer because of the rubber elasticity of the adhesive, so that, for example, the resiliency at protrudent part is greater, and the stress distribution is not uniform on the bonding surface. For this reason or other unidentified reason, depending on the intensity of the press force, even if the sealing of bonding surface is complete at the initial stage of the bonding of the film and the opposite member through the adhesive, it may occur that, when allowed to stand still, the bonding strength is lowered to thereby cause void formation with the passage of time, finally resulting in separation of the film from the opposite member.

By contrast, in the present invention, the other end face 1b of the pellicle frame 1 and the substrate 4 are stuck to each other through the adhesive 5 at a press force (sticking pressure) which is not lower than the above "adhesion pressure". The sticking at the above sticking pressure enables avoiding unfavorable sealing, preventing the occurrence of voids or separation at the passage of time and attaining complete sealing of the bonding surface.

From another viewpoint, the above adhesion pressure can be regarded as the minimum sticking pressure required for sticking the pellicle frame to the mask substrate while ensuring sealing capability.

The adhesion pressure changes depending on the type of employed adhesive, accordingly, the hardness of adhesive. Fig. 2 shows the relationship between the hardness of adhesive (axis of abscissas, unit: gf) and the adhesion pressure (axis of ordinates, unit: kgf), exhibited at a sticking time of 30 sec. The upward curve of Fig. 2 indicates the adhesion pressure.

It is seen from Fig. 2 that the sticking pressure must not be lower than the adhesion pressure in the step of causing the pellicle frame and the substrate to adhere to each other.

On the other hand, the minimisation of the sticking pressure is desired for reducing the strain of the pellicle, especially, the pellicle frame at the time of the sticking. It is generally preferred that the sticking pressure be up to 20 kgf, especially, up to 10 kgf.

When the sticking pressure is too low, especially, when the sticking pressure is lower than the adhesion pressure, voids attributed to the minute irregularities of the surface of the adhesive layer remain between the adhesive layer and the mask substrate as the opposite member, and complete adherence is not attained between the surface of the adhesive layer and the opposite member. Therefore, even if the adhesive having the same hardness and exhibiting the same value of 180-degree peeling bond strength described below, namely, exactly the same adhesive is used, the peeling strength naturally drops with sealing properties deteriorated under these sticking conditions.

This aspect will further be described. Different adhesives exhibit different 180-degree peeling bond strengths (adhesive strengths), even if their hardness values are identical. For example, with respect to the silicone, urethane and acrylic adhesives, when, for example, adhesives are different in the composition ratios of a plurality of their components from each other, the adhesives exhibit different values of 180-degree peeling bond strength, as shown in Fig. 3, even if the adhesive hardness values are identical with each other and even if the sticking pressures applied at the sticking step are identical with each other. As apparent from this, generally, the use of different adhesives results in different bond strengths. However, when use is made of adhesives within the left upper zone of the upward curve of Fig. 3, it is seen that, preferably, complete sealing of the bonding surface can be attained and there is no void or separation between the surface of the adhesive layer and the opposite member (substrate) to enable maintaining excellent bonding condition. In Fig. 3, the axis of abscissas indicates the hardness of adhesive (gf) while the axis of ordinates indicates the 180-degree peeling bond strength (kg/25 mm width).

### 〈180-degree peeling bond strength〉

The 180-degree peeling bond strength is a bond strength exhibited at the peeling of the pellicle or pellicle frame stuck to the substrate at a specified sticking pressure. It provides the measure for evaluating the adherence intrinsic to the employed adhesive.

The 180-degree peeling bond strength is determined by measuring the bond strength of the adhesive in accordance with Japanese Industrial Standard K 6854 (corresponding to ASTM D 1876) as described later.

In the present invention, it is preferred that the thus determined 180-degree peeling bond strength of the adhesive generally be at least 0.6 kg/25 mm width, especially, from 0.6 to 4 kg/25 mm width, still especially, 0.8 to 3.0 kg/25 mm width and, yet still especially, 0.8 to 2.8 kg/25 mm width.

When the 180-degree peeling bond strength is in the above ranges, the bonding surfaces of the adhesive layer 5 provided by coating on, for example, the bottom face, i.e., other end face 1b of the pellicle frame and the substrate 4 are completely sealed and there is no void or separation therebetween to thereby attain desirable bonding condition, so that there can be avoided entrance of waste (dust), etc. through the bonding part of the pellicle and the substrate 4, and adherence of waste onto the substrate 4, for example, the mask or reticle.

In the present invention, among the above adhesives, preferred use is made of those having a hardness of up to 200 gf, especially, from 60 to 200 gf and, still especially, from 60 to 150 gf and having a 180-degree peeling bond strength of at least 0.6 kg/25 mm width, especially, from 0.6 to 4 kg/25 mm width, still especially, 0.8 to 3.0 kg/25 mm width and, yet still especially, 0.8 to 2.8 kg/25 mm width.

### 〈Sticking time〉

In the present invention, the time during which the sticking is maintained at the above sticking pressure, namely, the sticking time is preferably up to 180 sec, still preferably, up to 60 sec, yet still preferably, up to 30 sec and, optimally, from 10 to 30 sec, although it depends on the sticking pressure, etc. and cannot be unitarily determined. Causing the pellicle frame and the substrate to adhere to each other through the adhesive under the above sticking pressure for the above short sticking time enables completely sealing the bonding surfaces (contact surfaces), avoiding peeling and realizing excellent operation efficiency.

### 〈Pellicle〉

As the pellicle 3, the pellicle frame 1 and the pellicle film (thin film) constructing the pellicle 3, and the adhesive for bonding the pellicle frame 3 and the pellicle film, use can be made of not only those described below but also conventional materials as described in, for example, Japanese Patent Laid-open Publication Nos. 6(1994)-67409, 6(1994)- 289599 and 6(1994)-301199. Also, those described below can be used in combination with such conventional materials. For example, the pellicle frame can be composed of a metal such as aluminum, an aluminum alloy, an alumite treated aluminum or stainless steel, polyethylene, a glass or the like.

The pellicle film (thin film) can be obtained, for example, by dissolving, for example, nitrocellulose, cellulose propionate, fluorinated organic material "Cytop CTXS type" or "Cytop CTXA type" (trade name, produced by Asahi Glass Co., Ltd.), copolymer of tetrafluoroethylene and cyclic perfluoroether group containing fluorinated monomer "Teflon AF" ( trade name, produced by E.I. DuPont de Nemours & Co., Inc., U.S.A.) in, for example, a fluorinated solvent and converting the solution into a film.

Examples of adhesives (adhesives) suitably employed for securing the pellicle film to the pellicle frame include adhesives containing the above fluorinated organic material, acrylic resins, silicone resins, etc.

Although mainly the mode of sticking the pellicle 3 to the substrate 4 has been described above, in the present invention, the substrate 4 may first be stuck to a lower end face (bottom face) of the pellicle 1 not furnished with a pellicle film, followed by bonding the pellicle film 2 to upper end face 1a of the pellicle frame 1.

### adhesive furnished pellicle for ultraviolet and pellicle case

Preferred forms of the adhesive furnished pellicles for ultraviolet and pellicle cases especially suitable to ultraviolet with a wavelength of 140 to 200 nm, among the various pellicles found by the inventors, inclusive of the above pellicles, will be described in greater detail below with reference to the drawings.

The adhesive furnished pellicle of the present invention is suitable to ultraviolet with a wavelength of 140 to 200 nm.

This adhesive furnished pellicle will be illustrated referring to Fig. 5.

The adhesive furnished pellicle 11 of Fig. 5 comprises pellicle film 12, pellicle frame (holding frame) 14 adapted to hold the pellicle film 12 in extended form through adhesive (a) layer 13 and adhesive (b) layer 15 capable of securing the pellicle frame 14 to item to be protected (mask substrate or substrate) 16 such as a photomask or a reticle.

The pellicle film 12 is composed of a film forming material having an excellent transmittance for ultraviolet with a wavelength of 140 to 200 nm. Specifically, the film forming material preferably exhibits average light transmittance T of at least 90% within a wave range of exposure light source. The average light transmittance T is a value obtained by taking identical numbers of light transmittance interference wave troughs and crests occurring within the above wave range and calculating an average.

It is preferred that the pellicle film 12 have a strength permitting repeated use. For example, it is preferred that the tensile strength and the bending strength of the film forming material be at least about 100 kg/cm² and at least about 200 kg/cm², respectively.

Although any organic polymer can be used as the film forming material without any particular limitation as long as it exhibits the above high light transmittance, has a molecular structure of high interatomic bonding energy and is resistant to photodecomposition, it is preferred in the present invention that the organic polymer be amorphous.

Further, it is preferred that the organic polymer be excellent in the light transmittance from at least 200 nm short wave ultraviolet region to visible light region.

Examples of these organic polymers include those whose main chain is composed of, for example, C-C bonds, C-O bonds or Si-O bonds and whose branch chain group is composed of, for example, an alkyl group such as methyl, fluorine, a fluorinated alkyl group, a cycloalkyl group or a fluorinated cycloalkyl group. These organic polymers may have, for example, a linear structure, a branched structure, a ring structure, or a crosslinked structure.

More specifically, use can be made of fluororesins such as polytetrafluoroethylene (PTFE) and tetrafluoroethylene/hexafluoropropylene copolymer (FEP), silicone polymers such as dimethylpolysiloxane and fluorosilicone polymers. Further, use can be made of commercially available fluororesins, Cytop (trade name) and Teflon AF (trade name) of the following formulae:

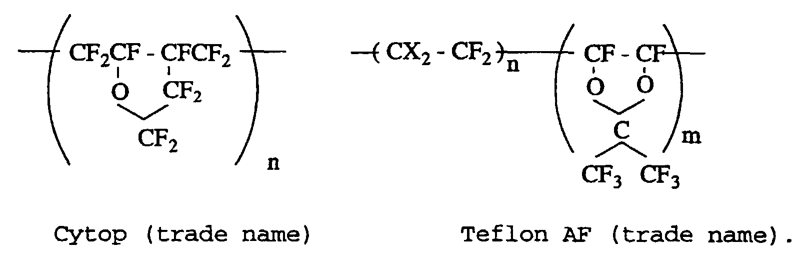

The light transmittance at wave range λ = 140 to 200 nm of each of the above organic polymers can be calculated by the molecular orbital method. Specifically, the light absorption spectrum resulting from electron excitation (simulation) can be presumed by calculating the electron energy level of the polymer by the molecular orbital method and determining the energy gap between HOMO (highest occupied molecular orbital) and LUMO (lowest unoccupied molecular orbital).

The thickness of the above pellicle film 12 is not particularly limited as long as the pellicle film has a required strength and the aberration at the time of exposure is slight. For example, the film thickness preferably ranges from 0.1 to 10 µm. The film thickness can be selected from among the values of the above range by calculating a thickness such that the transmittance for exposure wavelength is high by the formula: 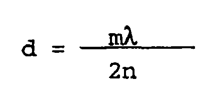 wherein m is an integer of 1 or greater, d represents the thickness of pellicle film (when the film is composed of a single layer), n represents the refractive index of polymer, and λ represents the exposure wavelength (e.g., 193 nm in the use of ArF excimer laser).

The above pellicle film 12 can be produced by the use of any of a wide variety of conventional pellicle film producing processes as long as, during the production, use is not made of the below described compound, especially, solvent which, when irradiated with ultraviolet with a wavelength of 140 to 200 nm, generates radicals. For example, the organic polymer can be formed into a film by the rotary film forming method in which an organic polymer solution or suspension is applied onto a clean smooth substrate and a spinner is rotated, the immersion method in which a substrate of, for example, glass having a clean smooth surface is immersed in an organic polymer solution or suspension and lifted up to thereby form a thin film, the vapor deposition method, or the organic polymer machining or fusion molding method.

The thus obtained thin film is dried by, for example, hot air or infrared irradiation and, when the suspension is used, further sintered. Thereafter, the thin film is stripped from the substrate, thereby obtaining the pellicle film (single layer film).

Moreover, the thin film (pellicle film 12) can be obtained by the method in which an organic polymer solution is spread on the surface of a liquid having a specific gravity and a surface tension which are greater than those of the organic polymer solution and is, as it is, formed into a thin film (pellicle film).

It is desired that the thus obtained pellicle film 12 do not contain any compound which, when irradiated with ultraviolet with a wavelength of 140 to 200 nm, generates radicals.

The above pellicle film 12 may optionally be fitted with an antireflection coating (not shown).

In the present invention, the thus produced pellicle film 12 is held in extended form through adhesive (a) layer 13 by means of pellicle frame 14, preferably, made of aluminum.

The pellicle frame 14 has its bottom furnished with adhesive (b) layer 15. At the time of use, the adhesive furnished pellicle 11 is secured through the adhesive (b) layer 15 to substrate 16 such as a mask or a reticle as an item to be protected.

Generally, for example, an acrylic, a silicone or an epoxy adhesive is used as the above adhesive (a). The adhesive (b) is generally based on, for example, ethylene/vinyl acetate copolymer, butyl methacrylic acid resin, polystyrene or polyisobutylene.

Before the use, i.e., before the sticking of the adhesive furnished pellicle 11 to the item to be protected 16, the surface of the adhesive (b) layer 15 is generally covered with a liner (not shown) of polyethylene terephthalate (PET).

The inner wall side of the pellicle frame 14 may be fitted with adhesive (c) layer 17. The adhesive (c) is generally based on, for example, an acrylic, a SEBS or an adhesive fluorinated grease.

In the present invention, in the above constituted adhesive furnished pellicle for ultraviolet (adhesive furnished pellicle) 11, a compound which can be adsorbed on or absorbed by the pellicle film and which, when irradiated with ultraviolet with a wavelength of 140 to 200 nm, generates radicals is generated from the adhesive (a) layer and the adhesive (b) layer in an amount of not exceeding 200 ppm, preferably, not exceeding 100 ppm.

Generally, commercially available adhesives contain various compounds, for example, as a solvent. Examples of such compounds include:
aromatic compounds such as benzene, toluene, m-xylene, p-xylene, mesitylene, cumene, isopropylcumene, pseudocumene, benzene trifluoride, m-xylene hexafluoride, butyl benzoate and cumene hydroxides including: 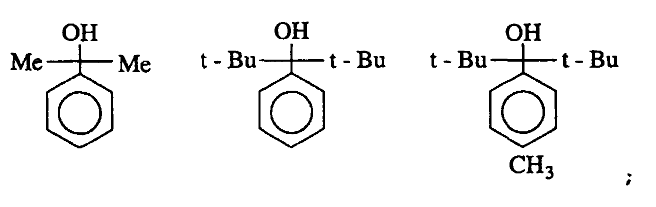
ketones such as acetone, methyl ethyl ketone, methyl isobutyl ketone and cyclohexanone;
nitrogenous compounds such as ammonia, acrylonitrile, N-methylpyrrolidone, trimethylamine and hexamethyldisilazane;
esters such as n-butyl acetate, methyl methacrylate, ethyl lactate, ethyl ethoxypropionate, ethylcellosolve acetate and propylene glycol monomethyl ether acetate;
unsaturated compounds such as cyclohexene, C₅H₁₀, methylcyclohexene, tetrachloroethylene, diacetylene and dimethylmethylenenorbornane; and
alcohols such as isopropyl alcohol, t-butyl alcohol, 2-ethylhexyl alcohol, C₁₁H₂₃OH, C₁₂H₂₅OH, C₁₃H₂₇OH, ethylene glycol monoethyl ether and propylene glycol monomethyl ether.

In the present invention, as the adhesive (a) and adhesive (b), use is made of adhesives wherein the amount of generated ketone, aromatic compound and nitrogenous compound, which are especially selected from among the above compounds generally contained in adhesives as the compound which can be adsorbed on or absorbed by the pellicle film and which, when irradiated with ultraviolet with a wavelength of 140 to 200 nm, generates radicals is 200 ppm.

These desired adhesives can be obtained by, for example, the method in which, in the adhesive producing process, the above compounds are removed by distillation or extraction from the starting materials, or the method in which heating in vacuum is conducted at temperature such that the principal components of the adhesive are not decomposed.

In the present invention, from the viewpoint of appearance influenced by whitening of the pellicle film, it is preferred that compounds such as esters as well as the aromatic compound, ketone and nitrogenous compound be removed from the adhesive (a) and adhesive (b). Further, in the present invention, it is preferred that none of the ketone, aromatic compound, nitrogenous compound, etc. be generated from other members than the adhesive (a) and adhesive (b) as well.

For example, the adhesive 17 applied on the inner wall generally contains compounds such as toluene, butyl acetate, cumene, perhydronaphthalene, butylbenzene, 4-methyl-2,6-di(t-butyl)phenol. The liner covering the adhesive (b) layer contains compounds such as toluene, 2-ethyl-1-hexyl alcohol, diethyl phthalate and di(2-ethyl-1-hexyl) phthalate. It is preferred that treatment be effected to avoid the generation of these compounds.

The generation of these compounds from the inner wall adhesive and the liner can be avoided by the same treatment as conducted for the adhesive (a) and adhesive (b).

Moreover, in the present invention, it is preferred that, in the pellicle case adapted to contain the above adhesive furnished pellicle, the amount of generated compound, this compound being one which can be adsorbed on or absorbed by the pellicle film and which, when irradiated with ultraviolet with a wavelength of 140 to 200 nm, generates radicals, be up to 200 ppm, especially, up to 100 ppm.

Among the materials mentioned hereinbefore, for example, metals such as aluminum, aluminum alloys and SUS and glasses are preferably employed for forming this pellicle case.

Furthermore, organic polymers such as polypropylene, Vyon, antistatic ABS and ABS commonly employed as pellicle case materials can be utilized in the present invention as long as the generation of the above compound does not exceed 200 ppm.

These organic polymers generally contain compounds such as 1-butyl alcohol, methyl acrylate, methyl methacrylate, 2ethyl-1-hexyl alcohol, isopropylcumene and butyl benzoate.

These organic polymers can be used as the material for forming the pellicle case of the present invention if the above compound is removed by subjecting them to treatment such as bubbling or reducing pressure while the organic polymer is in a molten state.

### EFFECT OF THE INVENTION

The method of sticking a pellicle to a substrate such as a mask according to the present invention enables not only lowering the sticking pressure applied when the pellicle (mask protector) is stuck to the mask or the like which is employed in the photolilthography of the process of producing integrated circuits, liquid crystal displays and the like as compared with the commonly employed sticking pressure but also attaining the sticking within a short period of time.

That is, in this method using highly flexible specified adhesive whose hardness is up to 200 gf, preferably, up to 150 gf, the sticking can be conducted at the sticking pressure not lower than the adhesion pressure but as low as generally up to 20 kgf, preferably, up to 10 kgf within a time as extremely short as up to 180 sec, preferably, up to 60 sec and, still preferably, up to 30 sec.

Further, in this method, even if the adhesive layer is deformed by external force, the substrate and the pellicle frame ate bonded together with a bonding strength capable of absorbing the deformation of the adhesive layer. Thus, the substrate and the pellicle frame are not separated from each other. Therefore, the strain of the mask or the like, which is likely to occur at the sticking of the pellicle, can be avoided, so that the mask protector fitted substrate which is free from disadvantages such as partial enlargement or double photographing of pattern transferred to a semiconductor wafer can be provided.

Still further, in the method of sticking a pellicle to a substrate such as a mask according to the present invention, no interstice permitting the entrance of dust, etc. entrained by air flow is formed at the adhesive bonding interface of the pellicle frame and the mask substrate of the obtained substrate with the pellicle stuck thereto and, hence, the bonding interface is in a completely sealed condition. Thus, the contamination of the semiconductor wafer with dust, etc. can be avoided.

The adhesive furnished pellicle of the present invention exhibits excellent light resistance when use is made of an exposure light source of ultraviolet with a wavelength of 140 to 200 nm.

The above adhesive furnished pellicle can suitably be employed when use is made of an exposure light source emitting ultraviolet with a wavelength of 140 to 200 nm, for example, ArF excimer laser (λ = 193 nm) or F₂ laser (λ = 157 nm), especially, ArF excimer laser.

Moreover, the pellicle case of the present invention substantially does not contain any compound which deteriorates the light resistance of the pellicle, especially, the adhesive furnished pellicle, so that it is suitably employed for accommodating the pellicle.

### EXAMPLE

The method of sticking a pellicle to an item to be protected, substrate with a pellicle stuck thereto obtained by the above method, adhesive furnished pellicle for ultraviolet and pellicle case according to the present invention will be described in greater detail below with reference to the following Examples, which in no way limit the scope of the invention.

In the Examples and Comparative Example, the hardness and adhesive strength of each adhesive were measured by the following methods.

### (a) Hardness of adhesive:

The hardness of the adhesives was measured with the use of rubber hardness meter GS-706 (JIS A type) manufactured by Teclock Corporation in accordance with Japanese Industrial Standard K 6301 (corresponding to ASTM D 2240).

### (b) Pressure sensitive adhesive strength (180-degree peeling bond strength):

The bond strength of each adhesive was measured in accordance with Japanese Industrial Standard K 6854 (corresponding to ASTM D 1876).

Illustratively, first, a film of polyethylene terephthalate (PET) having a thickness of 38 µm, a width of 25 mm and a length of 125 mm was coated with the adhesive so that the thickness thereof was 50 ± 10 µm. The resultant adhesive coated film was overlaid with a stainless steel plate so that the adhesive layer side was brought into contact with the stainless steel plate. Thus, a laminate (stainless steel plate/adhesive layer/PET film) was obtained. Press roll was applied to the laminate surface film at a press force (sticking pressure) of 2 kg/cm² and moved forwards and backwards once to thereby effect a sticking of the laminate. Thus, a test specimen was obtained.

The 180-degree peeling bond strength of the test specimen was measured. The measurement was conducted at 30°C by horizontally pulling the PET film in a direction from one end toward the opposite end of the test specimen at a pulling speed of 200 mm/min so that the PET film was reversed. The strength required for peeling the PET film from the stainless steel plate was measured as the 180-degree peeling bond strength of the adhesive.

### Example 1

Protector for a mask (pellicle) 3 shown in Fig. 1 was stuck to mask substrate 4 with the use of hot-melt adhesive A containing polystyrene/butylene copolymer (hardness: 60 gf and 180-degree peeling bond strength: 2.8 kg/25 mm width) by pressing the former to the latter at a strength such that the adhesive 5 flowed out from pellicle frame 1.

The sticking pressure and sticking time were 6 kgf and 30 sec, respectively.

The thus obtained substrate with the pellicle stuck thereto had its bonding surfaces completely sealed, and no separation occurred.

### Comparative Example 1

In the same manner as in Example 1, protector for a mask 3 shown in Fig. 1 was stuck to mask substrate 4 with the use of conventional hot-melt adhesive B containing polystyrene/butylene copolymer (hardness: 240 gf and 180-degree peeling bond strength: 0.6 kg/25 mm width).

The sticking pressure was varied to find the sticking pressure at which the bonding surfaces were completely sealed and free from separation. The sticking pressure was 20 kgf, which was applied for 180 sec.

In the resultant substrate with the pellicle stuck thereto, the pellicle frame had a strain because of the application of high sticking pressure. The substrate with the pellicle stuck thereto was unsuitable to use for projecting circuit patterns onto a semiconductor wafer in photolithography.

### Example 2

With respect to the adhesive furnished pellicle in which the pellicle film was composed of Cytop (trade name) of the formula: 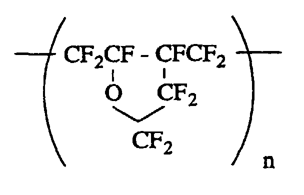 the influence of compound on the light resistance (film thickness reduction ratio) was tested under the following conditions:
Compound vapor concentration: 10,000 ppm,
Laser (ArF excimer laser) irradiation condition: 1 mJ/cm² p x 100 Hz, and
Laser exposure: 500 J/cm².

The results are given in Table 1.

It is apparent from the results that the light resistance of the pellicle film is extremely deteriorated when an aromatic compound, a ketone or a nitrogenous compound is present and that the light resistance can be improved by removing these compounds.

### Example 3

Testing was conducted in the same manner as in Example 2, except that the pellicle film material was changed to Teflon AF (trade name) of the formula:

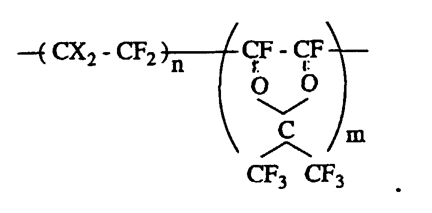

The results are given in Table 1.

It is apparent that the light resistance of the pellicle film is extremely deteriorated by an aromatic compound, a ketone or a nitrogenous compound, as in Example 2.

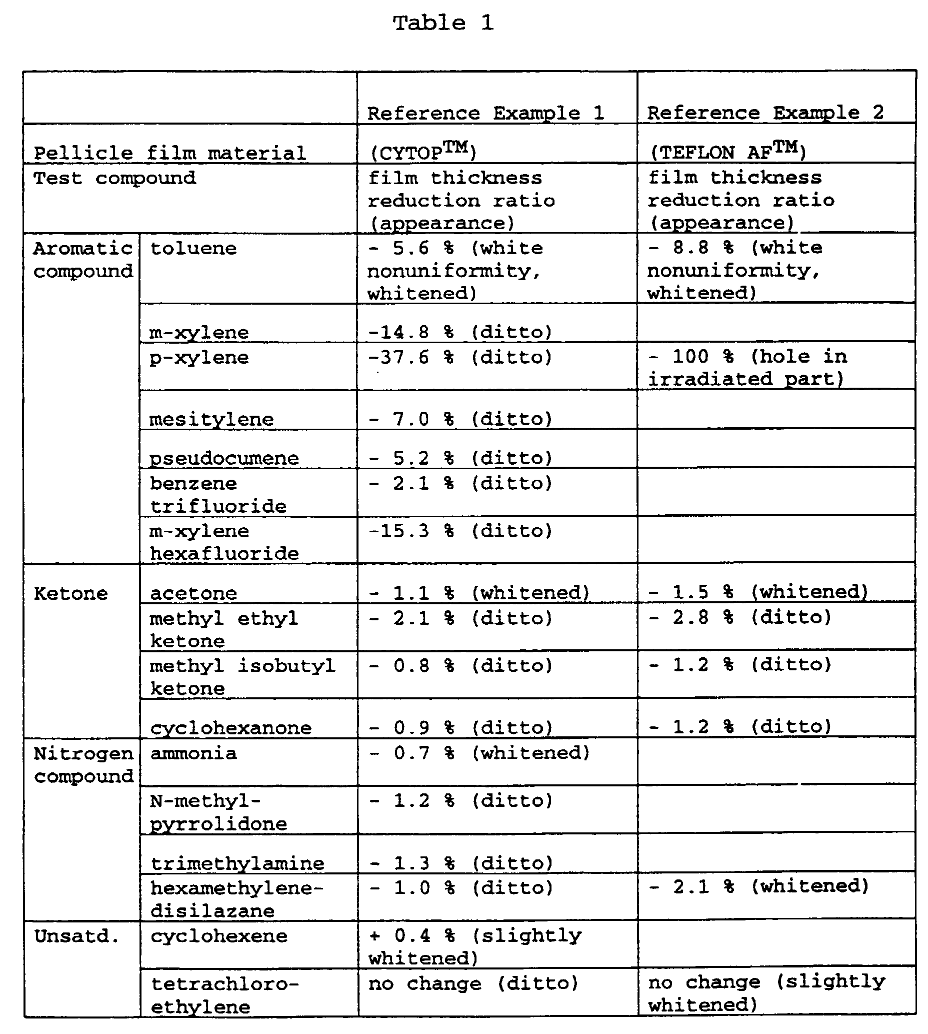

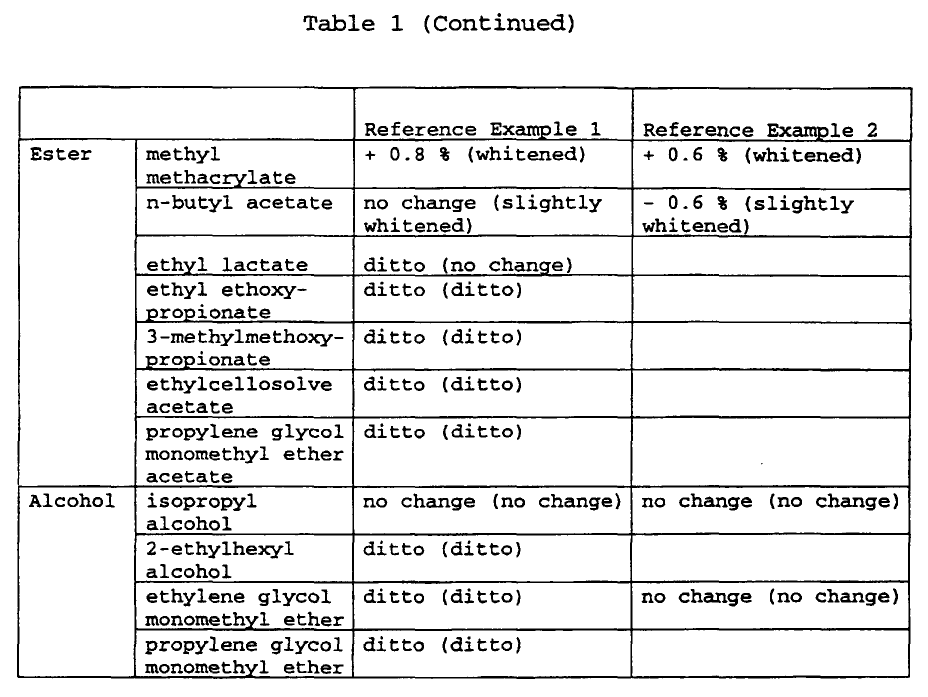

### Example 4

With respect to p-xylene which exhibited the greatest influence in Example 2, the effect of compound concentration on the light resistance was tested under the following conditions:
pellicle film material: Cytop (trade name),
compound: p-xylene (vapor concentration 20, 200, 2000 ppm), and
laser (ArF excimer laser) irradiation condition: 1 mJ/cm² p × 100 Hz.

The results are shown in Fig. 6.

It is seen that the light resistance is extremely deteriorated at a concentration of 200 ppm.

## Claims

1. A method of sticking a pellicle to an item to be protected, said pellicle comprising a pellicle frame with a size sufficient to enclose a mask pattern and a transparent thin film attached to one end face of the pellicle frame, which comprises:
pressing the pellicle to the item to be protected, in the state of an adhesive with a hardness of up to 200 gf interposed between the other end face of the pellicle frame and the item to be protected, at a sticking pressure not lower than an adhesion pressure intrinsic to the adhesive, so that the pellicle adheres to the item to be protected.

2. The method as claimed in claim 1, wherein the hardness of the adhesive is in the range of from 60 to 200 gf.

3. The method as claimed in claim 1 or 2, wherein the adhesive exhibits a 180-degree peeling bond strength of at least 0.6 kg/25 mm width.

4. The method as claimed in claim 1 or 2, wherein the hardness of the adhesive is in the range of from 60 to 150 gf, and the adhesive exhibits a 180-degree peeling bond strength of from 0.8 to 3 kg/25 mm width.

5. The method as claimed in any of claims 1 to 4, wherein the sticking pressure is not lower than the adhesion pressure intrinsic to the adhesive but does not exceed 20 kgf.

6. The method as claimed in any of claims 1 to 4, wherein the sticking pressure is not lower than the adhesion pressure intrinsic to the adhesive but does not exceed 10 kgf.

7. The method as claimed in claim 5 or 6, wherein the sticking pressure is maintained for a period of from 10 to 30 sec.

8. A substrate with a pellicle stuck thereto, obtained by the method of any of claims 1 to 7.

9. An adhesive furnished pellicle for ultraviolet with a wavelength of 140 to 200 nm, comprising a pellicle film, a pellicle frame adapted to hold the pellicle film in extended form through an adhesive (a) layer and an adhesive (b) layer capable of securing the pellicle frame to an item to be protected,
wherein the amount of generated compound does not exceed 200 ppm, said compound being one which is generated from the adhesive (a) layer and the adhesive (b) layer and can be adsorbed on or absorbed by the pellicle film and which, when irradiated with ultraviolet with a wavelength of 140 to 200 nm, generates radicals.

10. The pellicle as claimed in claim 9, wherein the compound is an aromatic compound, a ketone or a nitrogenous compound.

11. A case for an adhesive furnished pellicle for ultraviolet with a wavelength of 140 to 200 nm, said case adapted to accommodate the pellicle of claim 9,
wherein the amount of generated compound does not exceed 200 ppm, said compound being one which is generated from the case and can be adsorbed on or absorbed by the pellicle film and which, when irradiated with ultraviolet with a wavelength of 140 to 200 nm, generates radicals.
